# EUROPEAN PATENT APPLICATION

(11) **EP 1 585 176 A1**
(43) Date of publication of application: **12.10.2005**
(21) Application number: 03701774.6
(22) Date of filing: 17.01.2003
(51) Int. Cl.: H01L 27/108, H01L 21/8242

(54) **FERROELECTRIC CAPACITOR AND METHOD FOR FABRICATING THE SAME**

(71) Applicant: FUJITSU LIMITED, Kanagawa 211-8588 (JP)
(72) Inventor: KURASAWA, Masaki, C/O FUJITSU LIMITED, Kawasaki-shi, Kanagawa 211-8588 (JP)
(74) Representative: HOFFMANN EITLE
(86) International application number: PCT/JP2003/000379
(87) International publication number: WO 2004/066388

(57) **Abstract**

A ferroelectric capacitor including a bottom electrode layer, a ferroelectric layer on the bottom electrode layer, and a top electrode layer on the ferroelectric layer, in which a ferroelectric is formed on the bottom electrode layer so as to have a dominant axis of orientation, the bottom electrode layer has a multilayer structure, and the layers of the bottom electrode have larger coefficients of diffusion of component elements of the ferroelectric or compounds comprised of the component elements to the bottom electrode the closer the layers to the ferroelectric layer. This is produced by a method including a step of forming a ferroelectric layer by metal organic chemical vapor deposition and heating a substrate when forming this ferroelectric layer and a step of passing organometallic precursor including at least one type of the component elements of the ferroelectric layer to form the ferroelectric layer on the bottom electrode and form the component elements of the first layer of the bottom electrode contiguous with the ferroelectric layer and the component elements of the ferroelectric layer into an alloy or compound. A ferroelectric capacitor formed so that the morphology is good and the ferroelectric has a dominant axis of orientation is obtained.

## Description

### TECHNICAL FIELD

The present invention relates to a ferroelectric capacitor used mainly for a nonvolatile memory device and a method of production of the same.

### BACKGROUND ART

PZT [Pb (ZrₓTi₁₋ₓ) O₃] is a perovskite crystal structural material having ferroelectric properties and electrooptic properties and is used for nonvolatile memory devices, electrooptic devices, etc. having large spontaneous polarization.

Up until now, ferroelectric thin films have been formed by various film-forming methods. In general, thin film forming technologies are divided into physical vapor deposition (PVD) technologies and chemical processing technologies.

The PVD technologies used for forming ferroelectric thin films include electron beam vapor deposition, sputtering, laser ablation, etc. Chemical processing technologies include chemical solution deposition (CSD) and chemical vapor deposition (CVD).

The PVD technologies mainly have the advantages that they can form films by a low pressure of 10⁻⁵ Pa or less, give high purity and high cleanness, and give compatibility with semiconductor integrated circuit technologies, but have the defects of a low deposition speed, difficulty in control of the stoichiometric composition, high temperature annealing after deposition, etc.

CSD has the advantages of uniformity of molecules, a high deposition speed, reproducibility of composition, ease of introduction of a dopant, etc., but has the problems of the heat treatment after deposition causing the film to crack, the absence of use of a vacuum tank, so the occasional intermixture of impurities, a change in the composition necessitating a change in the starting materials, etc.

Among the above art, for the formation of ferroelectric thin film, metal organic chemical vapor deposition (MOCVD) is the most promising. MOCVD has the advantages of superior film uniformity and composition control, high film density, high deposition speed, superior step coverage, etc. In particular, the step coverage obtained by MOCVD is not obtainable by any other method. Further, the composition of the film, for example, the PZT, can be easily changed using the same materials by the flow rates of the materials.

Many of the reports of MOCVD relating to the formation of ferroelectric thin film use the bubbling method of bubbling liquid materials by a gas and sending them to a reaction chamber by a carrier gas, but the low film formation speed is a problem (for example, see Japanese Unexamined Patent Publication (Kokai) No. 5-17286). Further, the only Pb liquid material used when forming PZT is a tetraethyl lead-based toxic material. This is a problem. From the viewpoint of using nontoxic materials, there is sublimation for making solid organic materials sublimate and sending them to a reaction chamber, but this method is poor in reproducibility of the composition, film thickness, etc. (for example, see Japanese Unexamined Patent Publication (Kokai) No. 2002-319581) .

Recently, solution vaporized metal organic chemical vapor deposition for dissolving liquid organic materials or solid organic materials etc. in an organic solvent to obtain a precursor, vaporizing the liquid precursor by a vaporizer, and introducing the result into the reaction chamber to form a thin film has been researched. This method is considered promising in that it has the possibility of a good reproducibility and high film forming speed, but there are almost no reports indicating that a ferroelectric thin film having a high crystallinity and orientation is obtained. Almost all are non-oriented films or (100) oriented. There are virtually no reports of obtaining (111) orientation enabling utilization of the polarization of all crystal grains.

When using Pt for the bottom electrode as is the frequent practice with ferroelectric capacitors, there is the method of depositing an amorphous layer by sputtering or the sol-gel method, then using rapid heat treatment to orient the ferroelectric utilizing the strong self epitaxy of the (111) plane of Pt. However, in the case of for example metal organic deposition for heating the substrate and depositing and crystallizing the thin film, there was the problem for example that in PZT, the Pb would conspicuously diffuse to the bottom electrode side to form an alloy with the Pt and cause expansion of volume and thereby remarkably degrade the morphology.

When using Ir for the bottom electrode, since the reactivity with Pb is lower than Pt, no reaction layer is formed and the morphology is relatively good. However, compared with Pt, the self epitaxy is weak and the lattice mismatch with PZT is greater than Pt. Due to there, there was the problem of difficult orientation of the ferroelectric.

### DISCLOSURE OF INVENTION

The present invention has as its object to solve the problems of the prior art explained above and provide a ferroelectric capacitor formed so that the morphology is good and the ferroelectric has a dominant axis of orientation.

The present invention solves the above problem and provides a ferroelectric capacitor including a bottom electrode layer, a ferroelectric layer on the bottom electrode layer, and a top electrode layer on the ferroelectric layer, in which a ferroelectric is formed on the bottom electrode layer so as to have a dominant axis of orientation, the bottom electrode layer has a multilayer structure, and the layers of the bottom electrode have larger coefficients of diffusion of component elements of the ferroelectric or compounds comprised of the component elements to the bottom electrode the closer the layers to the ferroelectric layer.

The ferroelectric capacitor according to the present invention can be produced by a method including a step of forming a ferroelectric layer by metal organic chemical vapor deposition and heating a substrate when forming this ferroelectric layer and a step of passing organometallic precursor including at least one type of the component elements of the ferroelectric layer to form the ferroelectric layer on the bottom electrode and form the component elements of the first layer of the bottom electrode contiguous with the ferroelectric layer and the component elements of the ferroelectric layer into an alloy or compound.

### BRIEF DESCRIPTION OF DRAWINGS

FIG. 1 is a sectional SEM image of a PZT film grown on Pt.
FIG. 2 is a sectional SEM image of a PZT film grown on Ir.
FIG. 3 is an X-ray diffraction pattern of a PZT film formed on Ir shown in FIG. 2.
FIG. 4(a) to FIG. 4(e) are schematic views of steps of production of a ferroelectric capacitor of Example 1.
FIG. 5 is an XRD pattern of a PZT film of Example 1.
FIG. 6 is a graph of dependency of the amount of polarization on the supplied voltage at the PZT film of Example 1.
FIG. 7(a) to FIG. 7(f) are schematic views of steps of production of a ferroelectric capacitor of Example 2.
FIG. 8 is a SEM image of ferroelectric film of Example 2.
FIG. 9 is a schematic sectional view of a semiconductor device of Example 3.
FIG. 10(a) to FIG. 10(h) are schematic views of steps of production of a semiconductor device of Example 3.

### BEST MODE FOR CARRYING OUT THE INVENTION

In the present invention, by employing a configuration where the mismatch between the materials forming the first layer of the bottom electrode contiguous with the ferroelectric layer and the materials forming the ferroelectric layer becomes smaller, it is possible to obtain a ferroelectric capacitor formed so that the ferroelectric layer has a dominant axis of orientation.

In a preferred aspect, the ferroelectric capacitor according to the present invention may satisfy nᵢ>nᵢ₊₁ when the concentrations of the component elements of the ferroelectric or compounds comprised of the component elements in the i-th and i+1st layers of the bottom electrode counted from the ferroelectric layer side are nᵢ and nᵢ₊₁. Further, the first layer of the bottom electrode contiguous with the ferroelectric layer may be formed from an alloy or compound including the component elements of the ferroelectric.

The ferroelectric layer includes Pb and Ti or Pb, Zr, and Ti as component elements. Alternatively, the ferroelectric layer includes Pb and Ti or Pb, Zr, and Ti as component elements and further includes at least type of element selected from the group comprised of La, Ca, Sr, and Nb.

The ferroelectric layer is comprised of a ferroelectric including Pb and Ti or Pb, Zr, and Ti as component elements and a crystal orientation plane of (111). Alternatively, the ferroelectric layer is comprised of a ferroelectric including Pb and Ti or Pb, Zr, and Ti as component elements and a crystal orientation plane of (001).

A thickness of the first layer of the bottom electrode contiguous with the ferroelectric layer is for example not more than 20 nm. The first layer of the bottom electrode contiguous with the ferroelectric layer for example includes Pt as a component element and a second layer of the bottom electrode contiguous with the first layer of the bottom electrode includes Ir as a component element.

In a preferred aspect of the method for producing a ferroelectric capacitor according to the present invention, the ferroelectric layer is comprised of a perovskite ferroelectric including Pb, the first layer of the bottom electrode is formed from a compound including Pb by passing organometallic precursor including Pb and a carrier gas and oxygenation gas right before forming the ferroelectric layer, then the ferroelectric layer is formed. Alternatively, the ferroelectric layer is comprised of a ferroelectric including Pb, Zr, and Ti as component elements, Pb(THD)₂ is used as a Pb precursor, Zr(DMHD)₄ is used as a Zr precursor, and Ti(iPrO)₂(THD)₂ is used as a Ti precursor.

By using a bottom electrode as explained above according to the present invention, it is possible form the ferroelectric film on the bottom electrode so as to have a dominant axis of orientation.

In general, when orienting a thin film, a material having a strong self epitaxy and small lattice mismatch with thin film is sometimes used for the underlying layer. Further, sometimes the thin film is made a two-layer structure with the first layer grown with crystal nuclei called an "initial layer" or "seed layer" and used as a nucleus to grow a thin film. However, in the latter case, when considering the mass production of thin film, increased complexity of the process or control of parameters at the time of thin film growth become difficult. It is desirable to simplify the process as much as possible. For example, in the case of PZT, Pt having small lattice mismatch is often used.

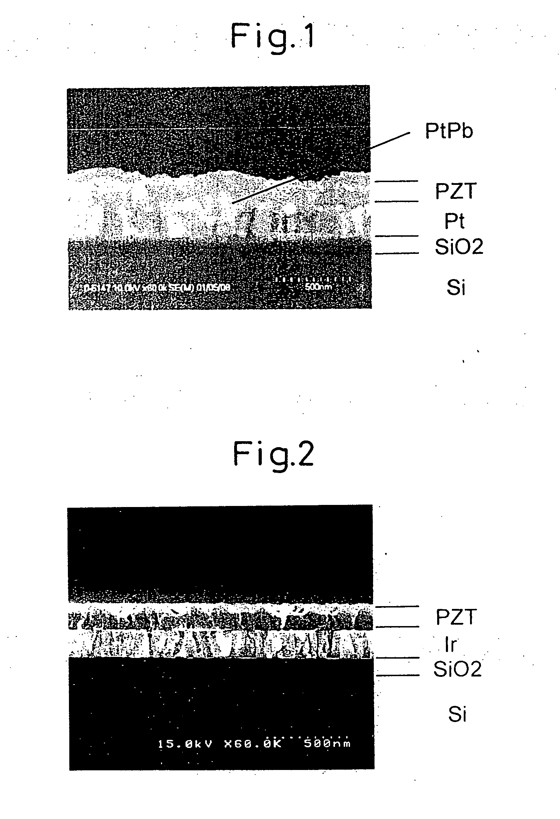

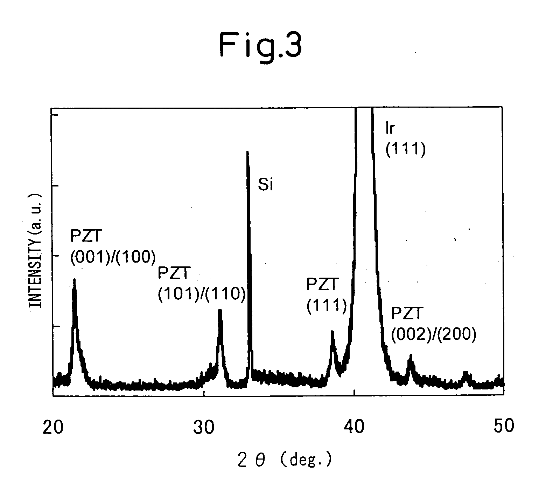

FIG. 1 shows a sectional SEM image of a PZT film grown on Pt. A reaction layer of Pt and Pb is observed at the boundary of the PZT and Pt. It is learned that due to the expansion of volume of the reaction layer of Pt and Pb, the morphology deteriorates. FIG. 2 shows a sectional SEM image of the PZT film formed on the Ir. No reaction product is seen at the boundary between the PZT and Ir. A good boundary is formed. However, as shown in FIG. 3, the orientation becomes random orientation.

Therefore, a Pt layer smaller in thickness compared with Ir is deposited on the Ir and first a Pb precursor is supplied to form a PbPt alloy on the Ir. The Pb supplied on the Pt diffuses in the Pt to react with it, but the reaction between Ir and Pb is lower compared with Pt, diffusion of Pb at the Pt-Ir boundary is suppressed, and the Pb diffuses uniformly in the Pt layer in the horizontal direction with respect to the substrate. Due to this, a uniform PtPb alloy is formed on the Ir. Further, since the thickness of the Pt is small and the Pb is further uniformly diffused, no local expansion occurs. This PtPb alloy has a smaller lattice mismatch with PZT compared with Pt, so later PZT layer is affected by the orientation of PtPb and becomes remarkably oriented.

Below, the present invention will be explained further by examples. However, the present invention is not limited by these examples in any way.

### Example 1

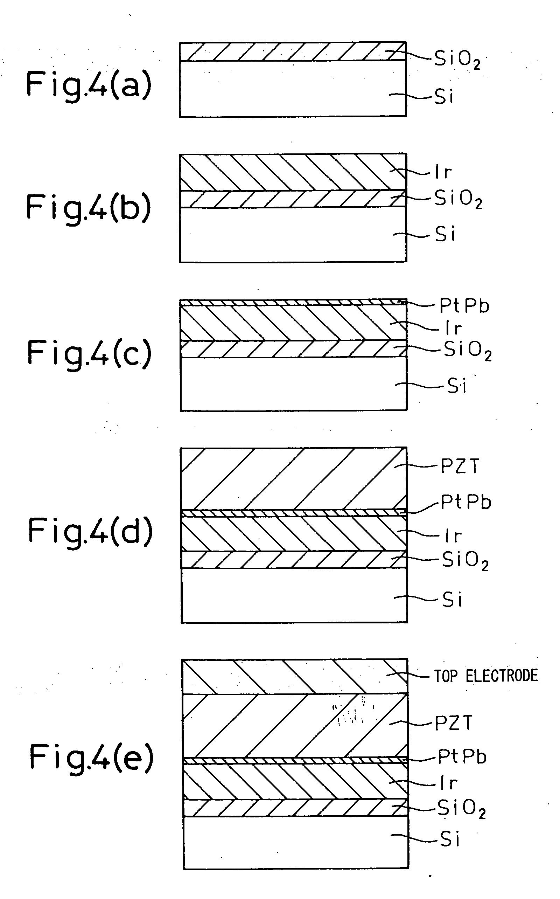

As the substrate, a 6-inch Si (100) substrate was used. The Si substrate was thermally oxidized to form a 100 nm thick SiO₂ layer (FIG. 4(a)). On top of this, an Ir layer was formed to a thickness of 150 nm by sputtering (FIG. 4(b)). As the bonding layer between the SiO₂ and Ir, a Ti layer and TiO₂ layer may also be formed. On the Ir layer, a PtPb layer was deposited to a thickness of about 10 nm using a PtPb alloy target by sputtering (FIG. 4(c)).

Next, the process of formation of a PZT film will be explained.

For forming a PZT film, metal organic chemical vapor deposition was used. As the organometallic material, Pb(THD)₂ [lead bis(tetramethylheptanedione)], Zr(DMHD)₄ [zirconium tetrakis(dimethylheptanedionate)], and Ti(iPrO)₂(THD)₂ [titanium (diisopropoxy)bis(tetramethylheptanedione)] were used. These materials were dissolved in THF (tetrahydrofuran) solvent to a concentration of 0.3 mol/L. This liquid was used as a starting precursor. This liquid precursor was introduced into a vaporizer controlled in flow rate by a liquid mass flow controller and held at 260°C to convert it into a gas. At this time, the carrier gas (N₂) was simultaneously introduced into the vaporizer at a flow rate of 300 sccm. The gasified organometallic precursor and carrier gas were mixed with oxygen gas in a gas mixing chamber above a reaction chamber and the result passed through a shower head to be introduced to a CVD reaction chamber.

As the wafer, the above obtained PbPt/Ir/SiO₂/Si was used. The wafer was placed on a susceptor at the top of the heating heater and was heated for 240 seconds so that the substrate temperature became a uniform 580°C. The pressure of the reaction chamber was adjusted so as to become 670 Pa in total pressure. The flow rate of the oxygen gas was made 2500 sccm. While heating the wafer, the material gas vaporized at the vaporizer was passed through an exhaust line and not sent to the CVD reaction chamber.

After heating the wafer, the precursor gases was mixed with oxygen gas in the gas mixing chamber and the result passed through a shower head to be introduced into the reaction chamber. The precursors were adjusted to a ratio of 0.78 by Pb/(Zr+Ti) flow rate ratio and a ratio of 0.46 by Zr/(Zr+Ti) flow rate ratio. Further, only the THF solvent was passed at a ratio of 1.33 by THF/(Pb+Zr+Ti) flow rate ratio and introduced into the vaporizer. After the substrate heating step, the valve connecting the vaporizer to the exhaust line was closed and simultaneously the valve of the piping from the vaporizer to the gas mixing chamber was opened to introduce the solvent to the mixing chamber together with the carrier gas. On the other hand, oxygen gas was also introduced into the mixing chamber and mixed with the precursor gases. The gas mixed at the gas mixing chamber was sent through a shower head to a deposition chamber maintained at 670 Pa and a film was formed on the substrate to a thickness of 120 nm (FIG. 4(d)).

Next, a top electrode of Pt, Ir, IrOₓ, etc. was formed on the PZT film (FIG. 4(e)).

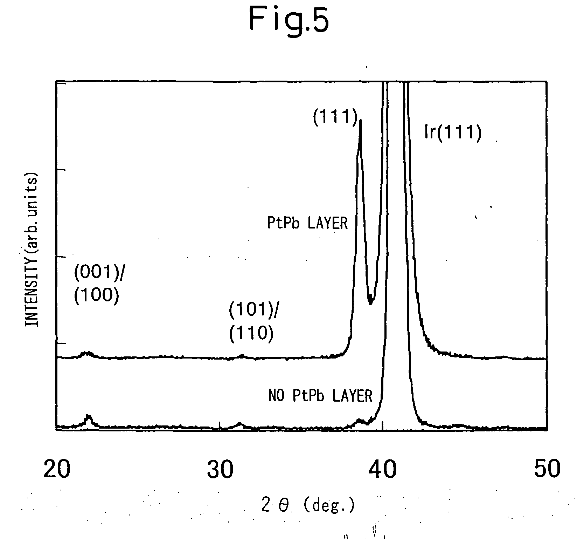

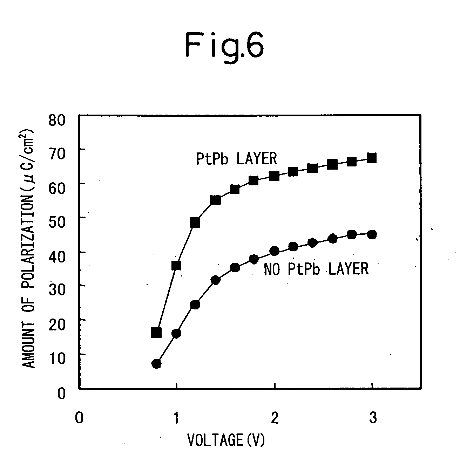

The PZT film formed by the above method was strongly (111) oriented as shown in FIG. 5. The (111) orientation rate was at least 90%. As reference, an X-ray diffraction pattern of the case of directly forming PZT on IR is also shown. Further, as shown in FIG. 6, this has an amount of polarization of at least 60 µC/cm² by an applied voltage of 1.8V.

### Example 2

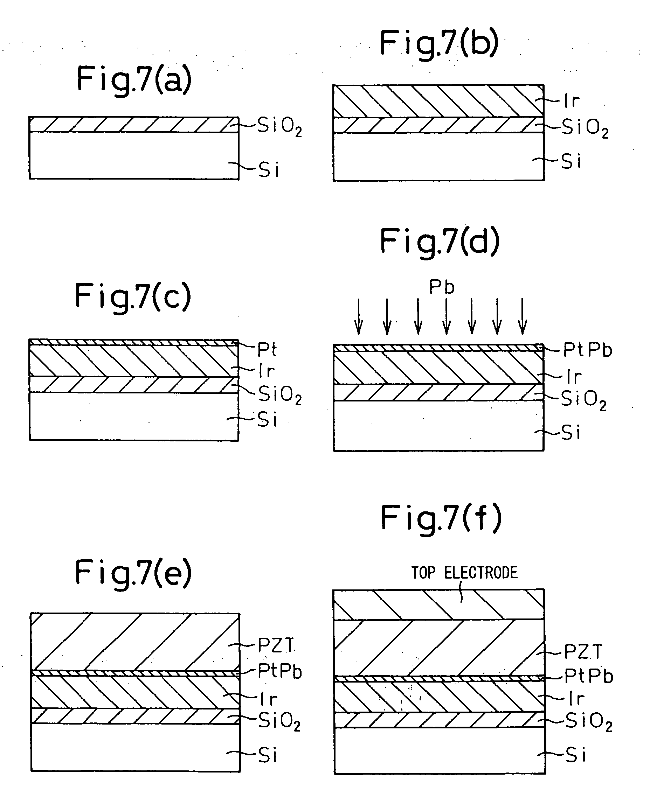

As the substrate, a 6-inch Si (100) substrate was used. The Si substrate was thermally oxidized to form a 100 nm thick SiO₂ layer (FIG. 7(a)). On top of this, an Ir layer was formed to a thickness of 150 nm by sputtering (FIG. 7(b)). As the bonding layer between the SiO₂ and Ir, a Ti layer and TiO₂ layer may also be formed. On the Ir layer, a Pt layer was deposited to a thickness of about 10 nm by sputtering (FIG. 7(c)).

Next, the process of forming a PZT film will be explained.

For forming a PZT film, metal organic chemical vapor deposition was used. As the organometallic materials, Pb(DPM)₂ [lead bis(dipivaroylmethanate)], Zr(DMHD)₄ [zirconium tetrakis(dimethylheptanedionate)], and Ti(iPrO)₂(DMP)₂ [titanium (diisopropoxy)bis(dipivaroylmethanate)] were used. These materials were dissolved in THF (tetrahydrofuran) solvent to a concentration of 0.3 mol/L. This liquid was used as a starting precursor. This liquid precursor was introduced into a vaporizer controlled in flow rate by a liquid mass flow controller and held at 260°C to convert it into a gas. At this time, a carrier gas (N₂) was simultaneously introduced into the vaporizer at a flow rate of 300 sccm. The gasified organometallic precursor and carrier gas were mixed with oxygen gas in a gas mixing chamber above a reaction chamber and the result passed through a shower head to be introduced to a CVD reaction chamber.

As the wafer, the above obtained Pt/Ir/SiO₂/Si was used. The wafer was placed on a susceptor at the top of the heating heater and was heated for 240 seconds so that the substrate temperature became a uniform 580°C. The pressure of the reaction chamber was adjusted so as to become 670 Pa in total pressure. The flow rate of the oxygen gas was made 2500 sccm. While heating the wafer, the material gas vaporized at the vaporizer was passed through an exhaust line and not sent to the CVD reaction chamber.

After heating the wafer, first only the Pb(DPM)₂/THF precursor was supplied on to the wafer at a flow rate of 0.2 to 0.5 ml/min for 10 to 30 seconds. Due to this, the Pt layer and Pb reacted and a PtPb layer was formed (FIG. 7(d)). After this, the Zr and Ti precursors were supplied and the vaporized Pb, Zr, and Ti precursor gases were mixed with oxygen gas in a gas mixing chamber. The result was passed through a shower head to be introduced into the reaction chamber. The precursors were adjusted to a ratio of 0.78 by Pb/(Zr+Ti) flow rate ratio and a ratio of 0.46 by Zr/(Zr+Ti) flow rate ratio. Further, only the THF solvent was passed at a ratio of 1.33 by THF/(Pb+Zr+Ti) flow rate ratio and introduced into the vaporizer. After the substrate heating step, the valve connecting the vaporizer to the exhaust line was closed and simultaneously the valve of the piping from the vaporizer to the gas mixing chamber was opened to introduce the solvent to the mixing chamber together with the carrier gas. On the other hand, oxygen gas was also introduced into the mixing chamber and mixed with the precursor gases. The gas obtained by mixing at the gas mixing chamber was sent through a shower head to a deposition chamber maintained at 670 Pa and a film was formed on the substrate to a thickness of 120 nm (FIG. 7(e)).

As a top electrode, IrOₓ was formed by sputtering to a thickness of about 100 nm to form a capacitor (FIG. 7(f)).

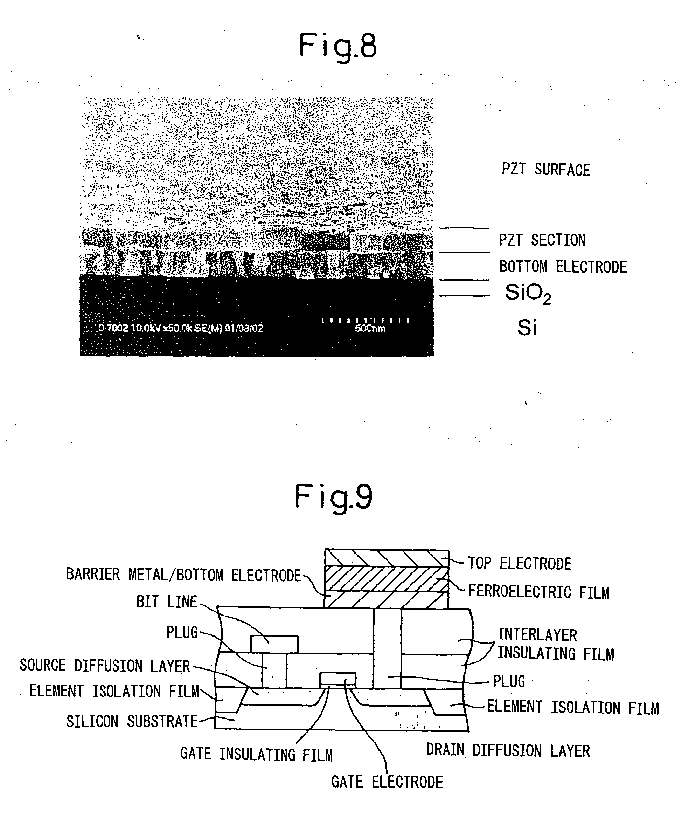

The PZT film formed by the above method, in the same way as the case of Example 1, was (111) oriented at least 90%. A sectional SEM image of this PZT film is shown in FIG. 8. In this structure, the Pt layer is thin, so no expansion of volume due to the reaction of Pt and Pb at the PZT/Pt boundary such as formed on a thick Pt (see FIG. 1) is seen and a good boundary state is obtained.

### Example 3

Here, the actual process of forming a ferroelectric capacitor on a semiconductor circuit board will be explained.

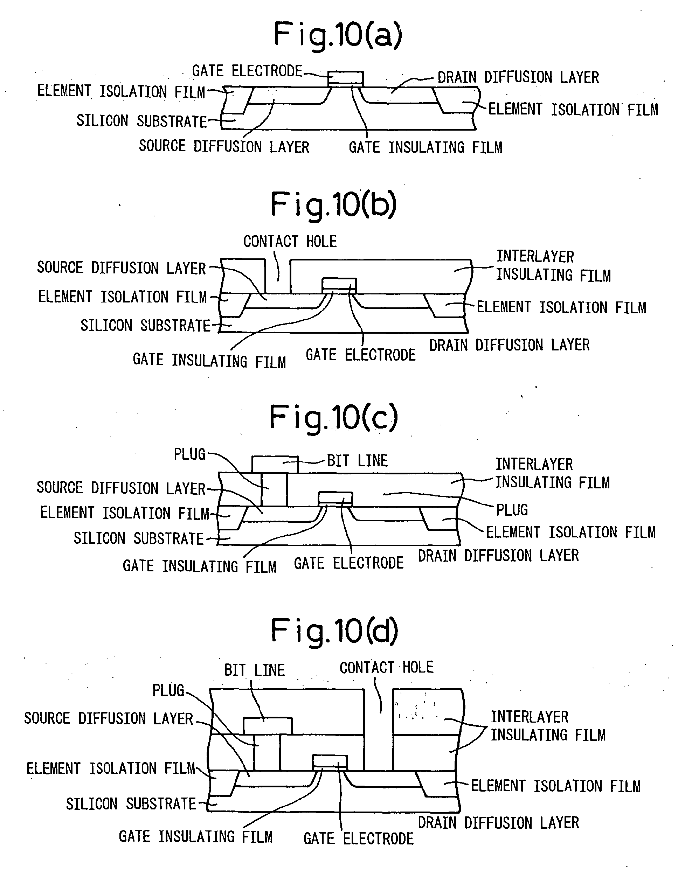

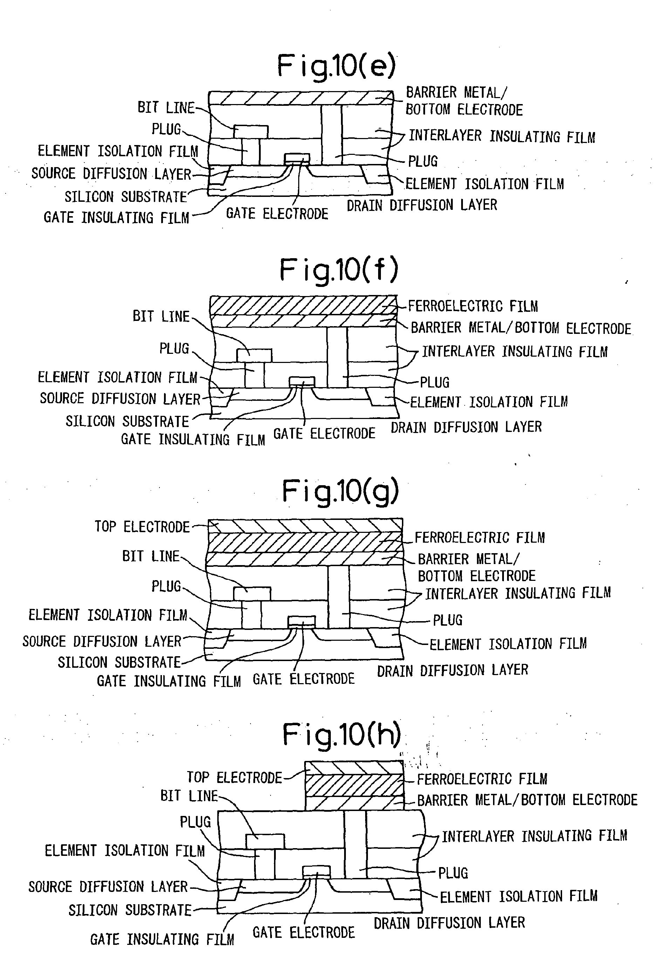

FIG. 9 is a schematic sectional view of the structure of a semiconductor device according to this example, while FIG. 10 is a sectional process chart of the method of production of the semiconductor device.

First, the structure of the semiconductor device will be explained using FIG. 9.

A silicon substrate is formed with a memory cell transistor having a gate electrode formed through a gate insulating film and source/drain diffusion layer formed on the silicon substrate at the two sides of the gate electrode. An interlayer insulating film is then formed on the silicon substrate formed with the memory cell transistor. Plugs electrically connected to the source/drain diffusion layer are buried in the interlayer insulating film. Bit lines electrically connected through the plugs to the source/drain diffusion layer are formed on the inter-layer insulating film. A further interlayer insulating film is formed on the interlayer insulating film formed with the bit lines. Plugs electrically connected to the source/drain diffusion layer are buried in the interlayer insulating film.

A barrier metal and bottom electrode is formed on the interlayer insulating film in which the plugs are buried. When using Ir as the bottom electrode, Ir, then a PtPb layer or Pt layer are formed. A capacitor dielectric film comprised of a PZT film is formed on the bottom electrode. A top electrode comprised of Pt or Ir or IrOₓ is formed on the dielectric film. Due to this, a ferroelectric capacitor comprised of a bottom electrode, a capacitor dielectric film, and a top electrode is configured.

Next, the method of production of a semiconductor device will be explained using FIG. 10.

First, a silicon substrate is for example formed with an element isolation film by the shallow trench method. Next, a memory cell transistor having a gate electrode formed through the gate insulating film and source/drain diffusion regions formed on the silicon substrate at the two sides of the gate electrode is formed on an element region defined by an element isolation film in the same way as the usual method of formation of a MOS transistor (FIG. 10(a)).

Next, a silicon oxide film is deposited on the silicon substrate formed with the memory cell transistor by for example CVD so as to form an interlayer insulating film comprised of a silicon oxide film.

Next, for example, the surface of the interlayer insulating film is polished by CMP (chemical mechanical polishing) to flatten the surface of the interlayer insulating film.

Next, a contact hole reaching the source/drain diffusion layer is formed in the interlayer insulating film by lithography technology and etching technology (FIG. 10(b)).

Next, for example, a tungsten (W) film is deposited by sputtering, then this is polished by CMP until the surface of the interlayer insulating film is exposed. In this way, a plug electrically connected to the source/drain diffusion layer buried in the contact hole is formed.

Next, for example, a W film is deposited by sputtering, then the W film is patterned by lithography technology and etching technology to form bit lines connected through the plug to the source/drain diffusion layer (FIG. 10(c)).

Next, a silicon oxide film is deposited by for example CVD on the interlayer insulating film formed with the bit lines to form an interlayer insulating film comprised of a silicon oxide film.

Next, a contact hole reaching the source/diffusion layer is formed in the interlayer insulating film by lithography technology and etching technology (FIG. 10(d)).

Next, for example, a W film is deposited by sputtering, then this is polished by CMP until the surface of the interlayer insulating film is exposed. In this way, a plug electrically connected to the source/drain diffusion layer buried in the contact hole is formed.

Next, a barrier metal and bottom electrode comprised of Ir are formed to a thickness of 150 nm (FIG. 10(e)).

Next, the process of formation of PZT will be explained.

As the organometallic material, Pb(DPM)₂ [lead bis(dipivaroylmethanate)], Zr(DMHD)₄ [zirconium tetrakis(dimethylheptanedionate)], and Ti(iPrO)₂(DPM)₂ [titanium (diisopropoxy)bis(dipivaroylmethanate)] were used. These materials were dissolved in THF (tetrahydrofuran) solvent to a concentration of 0.3 mol/L. This liquid was used as a starting precursor. This liquid precursor was introduced into a vaporizer controlled in flow rate by a liquid mass flow controller and held at 260°C to convert it into a gas. At this time, the carrier gas (N₂) was simultaneously introduced into the vaporizer at a flow rate of 300 sccm. The gasified organometallic precursor and carrier gas were mixed with oxygen gas in a gas mixing chamber above a reaction chamber and the result passed through a shower head to be introduced to a CVD reaction chamber.

As the wafer, the above obtained Pt/Ir/SiO₂/Si was used. The wafer was placed on a susceptor at the top of the heating heater and was heated for 240 seconds so that the substrate temperature became a uniform 580°C. The pressure of the reaction chamber was adjusted so as to become 670 Pa in total pressure. The flow rate of the oxygen gas was made 2500 sccm. While heating the wafer, the material gas vaporized at the vaporizer was passed through an exhaust line and not sent to the CVD reaction chamber.

When using a Pt layer for the bottom electrode, after heating the wafer, first the Pb(DPM)₂/THF precursor was supplied at a flow rate of 0.2 to 0.5 ml/min on to the wafer for 10 to 30 seconds. Due to this, the Pt layer and Pb reacted and a PtPb layer was formed. After this, the PZT film was formed. When using PtPb as the bottom electrode, this process is not performed.

Pb, Zr, and Ti precursor gases were mixed with oxygen gas in the gas mixing chamber and the result was passed through a shower head to introduce it to a reaction chamber. The precursors were adjusted to a ratio of 0.78 by Pb/(Zr+Ti) flow rate ratio and to a ratio of 0.46 by Zr/(Zr+Ti) flow rate ratio. Only the THF solvent was passed at a ratio of 1.33 by THF/(Pb+Zr+Ti) flow rate ratio and introduced to a vaporizer. After the substrate heating step, the valve connecting the exhaust line from the vaporizer was closed, at the same time the valve of the piping from the vaporizer to the gas mixing chamber was opened, and the vapor was introduced to the mixing chamber along with the carrier gas. On the other hand, the oxygen gas was also introduced into the mixing chamber and mixed with the precursor gases. The gas mixed in the gas mixing chamber was passed through a shower head and sent to a deposition chamber maintained at 670 Pa, and a film was formed until 120 nm thickness on the substrate (FIG. 10(f)).

Next, Pt, Ir, or IrOₓ were deposited on the PZT film to form a top electrode (FIG. 10(g)).

Next, this was patterned and etched by lithography technology and etching technology to isolate the bottom electrode, dielectric, and top electrode and form a ferroelectric capacitor (FIG. 10(h)).

### INDUSTRIAL APPLICABILITY

According to the present invention, it is possible to produce a ferroelectric capacitor formed so that the morphology is good and the ferroelectric has a dominant axis of orientation.

## Claims

1. A ferroelectric capacitor including a bottom electrode layer, a ferroelectric layer on the bottom electrode layer, and a top electrode layer on the ferroelectric layer, in which a ferroelectric is formed on the bottom electrode layer so as to have a dominant axis of orientation, the bottom electrode layer has a multilayer structure, and the layers of the bottom electrode have larger coefficients of diffusion of component elements of the ferroelectric or compounds comprised of the component elements to the bottom electrode the closer the layers to the ferroelectric layer.

2. A ferroelectric capacitor as set forth in claim 1, wherein nᵢ>nᵢ₊₁ when the concentrations of the component elements of the ferroelectric or compounds comprised of the component elements in the i-th and i+1st layers of the bottom electrode counted from the ferroelectric layer side are nᵢ and nᵢ₊₁.

3. A ferroelectric capacitor as set forth in claim 1 or 2, wherein the first layer of the bottom electrode contiguous with the ferroelectric layer is formed from an alloy or compound including the component elements of the ferroelectric.

4. A ferroelectric capacitor as set forth in any one of claims 1 to 3, wherein the ferroelectric layer includes Pb and Ti or Pb, Zr, and Ti as component elements.

5. A ferroelectric capacitor as set forth in any one of claims 1 to 3, wherein the ferroelectric layer includes Pb and Ti or Pb, Zr, and Ti as component elements and further includes at least type of element selected from the group comprised of La, Ca, Sr, and Nb.

6. A ferroelectric capacitor as set forth in any one of claims 1 to 5, wherein the ferroelectric layer is comprised of a ferroelectric including Pb and Ti or Pb, Zr, and Ti as component elements and a crystal orientation plane of (111).

7. A ferroelectric capacitor as set forth in any one of claims 1 to 5, wherein the ferroelectric layer is comprised of a ferroelectric including Pb and Ti or Pb, Zr, and Ti as component elements and a crystal orientation plane of (001).

8. A ferroelectric capacitor as set forth in any one of claims 1 to 7, wherein a thickness of the first layer of the bottom electrode contiguous with the ferroelectric layer is not more than 20 nm.

9. A ferroelectric capacitor as set forth in any one of claims 1 to 8, wherein the first layer of the bottom electrode contiguous with the ferroelectric layer includes Pt as a component element and a second bottom electrode layer contiguous with the first bottom electrode layer includes Ir as a component element.

10. A method for producing a ferroelectric capacitor as set forth in claim 1, including a step of forming a ferroelectric layer by metal organic chemical vapor deposition and heating a substrate when forming this ferroelectric layer and a step of passing organometallic precursor including at least one type of the component elements of the ferroelectric layer to form the ferroelectric layer on the bottom electrode and form the component elements of the first layer of the bottom electrode contiguous with the ferroelectric layer and the component elements of the ferroelectric layer into an alloy or compound.

11. A method as set forth in claim 10, wherein the ferroelectric layer is comprised of a perovskite ferroelectric including Pb, further comprising passing organometallic precursor including Pb and a carrier gas and oxygenation gas right before forming the ferroelectric layer, then forming the ferroelectric layer.

12. A method as set forth in claim 10, wherein the ferroelectric layer is comprised of a ferroelectric including Pb, Zr, and Ti as component elements, Pb(THD)₂ is used as a Pb precursor, Zr(DMFD)₄ is used as a Zr precursor, and Ti(iPrO)₂(THD)₂ is used as a Ti precursor.

13. A semiconductor device including a ferroelectric capacitor as set forth in claim 1.

14. A semiconductor device as set forth in claim 13, which is a memory device.
